# EUROPEAN PATENT APPLICATION

(11) **EP 4 667 519 A1**
(43) Date of publication of application: **24.12.2025**
(21) Application number: 25183212.7
(22) Date of filing: 17.06.2025
(51) Int. Cl.: C08K 3/04, H01R 3/00, H05K 9/00

(54) **ELECTROMAGNETIC INTERFERENCE (EMI) ABSORBERS INCLUDING CARBON NANOSTRUCTURE (CNS) FILLER WITHIN LIQUID CRYSTAL POLYMER (LCP) MATRIX**

(30) Priority: 21.06.2024 US 202463662625 P; 03.06.2025 US 202519226528
(71) Applicant: Laird Technologies, Inc., Chesterfield, MO 63017 (US)
(72) Inventor: MCBAIN, Douglas S., Chesterfield, 63017 (US); TRANTINA, Eric E., Chesterfield, 63017 (US)
(74) Representative: Lind Edlund Kenamets Intellectual Property AB

(57) **Abstract**

Disclosed are electromagnetic interference (EMI) absorbers and compositions including carbon nanostructure (CNS) filler within a liquid crystal polymer (LCP) matrix. In exemplary embodiments, an electromagnetic interference (EMI) absorber comprises carbon nanostructure filler within a matrix. The matrix comprises liquid crystal polymer. And the EMI absorber includes at least about 0.1 weight percent but not more than about 5 weight percent of the carbon nanostructure filler within the matrix.

## Description

### FIELD

The present disclosure relates to electromagnetic interference (EMI) absorbers including carbon nanostructure (CNS) filler within a liquid crystal polymer (LCP) matrix.

### BACKGROUND

This section provides background information related to the present disclosure which is not necessarily prior art.

A common problem in the operation of electronic devices is the generation of electromagnetic radiation within the electronic circuitry of the equipment. Such radiation may result in electromagnetic interference (EMI) or radio frequency interference (RFI), which can interfere with the operation of other electronic devices within a certain proximity. Without adequate shielding, EMI/RFI interference may cause degradation or complete loss of important signals, thereby rendering the electronic equipment inefficient or inoperable.

A common solution to ameliorate the effects of EMI/RFI is through the use of shields capable of absorbing and/or reflecting and/or redirecting EMI energy. These shields are typically employed to localize EMI/RFI within its source, and to insulate other devices proximal to the EMI/RFI source.

The term "EMI" as used herein should be considered to generally include and refer to EMI emissions and RFI emissions, and the term "electromagnetic" should be considered to generally include and refer to electromagnetic and radio frequency from external sources and internal sources. Accordingly, the term shielding (as used herein) broadly includes and refers to mitigating (or limiting) EMI and/or RFI, such as by absorbing, reflecting, blocking, and/or redirecting the energy or some combination thereof so that it no longer interferes, for example, for government compliance and/or for internal functionality of the electronic component system.

### DRAWINGS

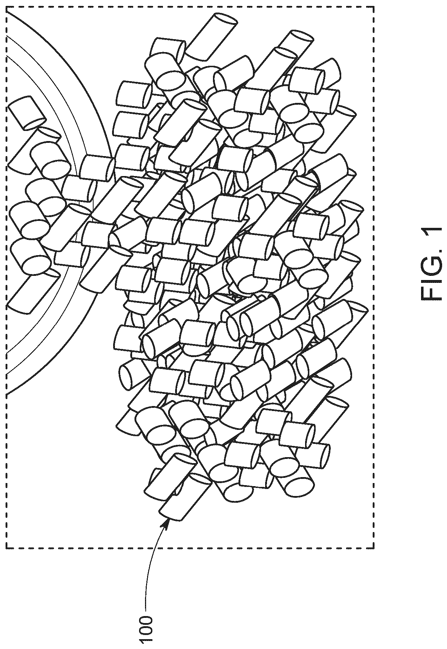

FIG. 1 shows injection moldable thermoplastic EMI absorber pellets including carbon nanostructure (CNS) filler (e.g., about 1.5 weight percent, etc.) within a liquid crystal polymer (LCP) matrix according to an exemplary embodiment of the present disclosure.

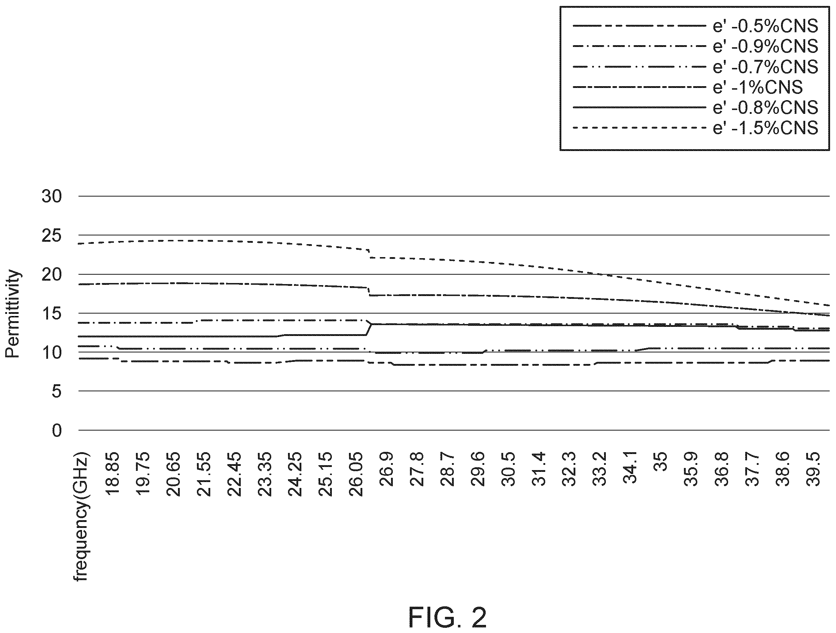

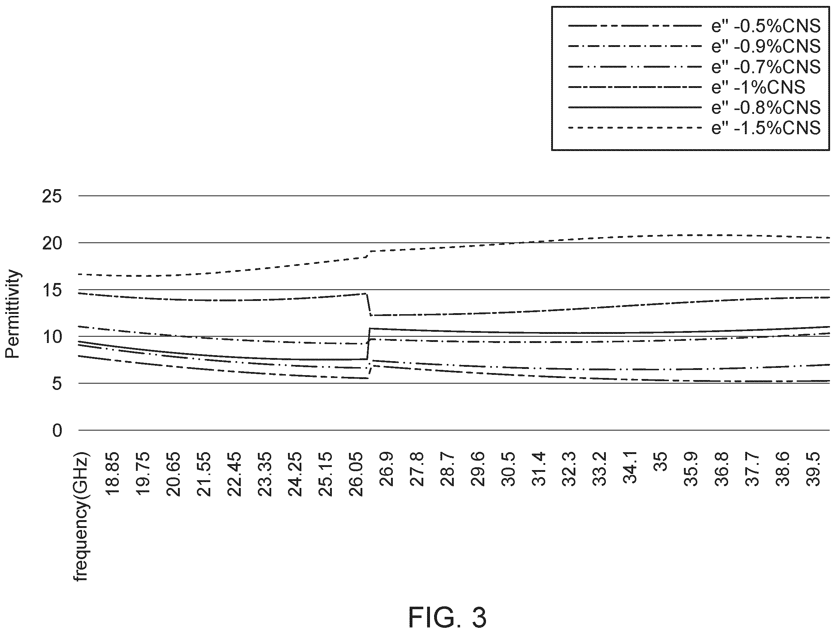

FIGS. 2 and 3 include line graphs of permittivity versus frequency from 18 gigahertz (GHz) to 40 GHz for six EMI absorbers having different carbon nanostructure (CNS) filler loadings (CNS weight percent of 0.5, 0.7, 0.8, 0.9, 1, and 1.5) within a liquid crystal polymer (LCP) matrix according to exemplary embodiments of the present disclosure.

### DETAILED DESCRIPTION

Example embodiments will now be described more fully with reference to the accompanying drawings.

As noted above, a common problem in the operation of electronic devices is the generation of electromagnetic radiation within the electronic circuitry of the equipment. Such radiation may result in electromagnetic interference (EMI) or radio frequency interference (RFI), which can interfere with the operation of other electronic devices within a certain proximity. Without adequate shielding, EMI/RFI interference may cause degradation or complete loss of important signals, thereby rendering the electronic equipment inefficient or inoperable.

The use of EMI absorbers to provide adequate EMI shielding is especially important in aerospace connectors for several reasons including signal integrity, regulatory compliance, reliability, and safety. Overall, EMI absorbers play an important role in ensuring the performance, reliability, and safety of aerospace connectors in demanding environments.

Regarding signal integrity, sensitive electronic signals in aerospace systems can be disrupted by electromagnetic interference. EMI absorbers may be used to help maintain signal integrity by reducing or eliminating interference that could degrade performance or cause malfunctions.

Aerospace equipment also must satisfy stringent regulatory standards for electromagnetic compatibility (EMC). EMI absorbers may be used to help ensure compliance with these regulations by minimizing electromagnetic emissions and susceptibility to external interference.

Reliability is a paramount concern in aerospace applications. EMI absorbers can be used to help improve the reliability of connectors by protecting electronic components from damage or malfunction caused by electromagnetic interference.

In addition, aerospace systems may operate in challenging environments where electromagnetic interference can pose safety risks. In which case, EMI absorbers may be used to help mitigate these safety risks by reducing or minimizing the potential for interference-related failures or malfunctions.

Disclosed herein are exemplary embodiments of EMI absorbers and EMI absorbing compositions (*e.g.,* injection moldable EMI absorbing compositions, pellets, *etc.*) including carbon nanostructure (CNS) filler within a liquid crystal polymer (LCP) matrix. Also disclosed are exemplary compositions for EMI absorbers and aerospace connectors including such EMI absorbers.

Advantageously, exemplary embodiments of the EMI absorbers and EMI absorbing compositions disclosed herein may provide or include one or more (but not necessarily any or all of) the following features and benefits. In exemplary embodiments, the EMI absorbers and EMI absorbing compositions (*e.g.,* injection moldable EMI absorbing compositions, pellets, *etc.*) disclosed herein may be sufficient lightweight for aerospace applications and/or have sufficiently low viscosity and good flowability for easily pouring, casting, or molding (*e.g.,* injection molding, *etc.*) into shapes or patterns (*e.g.,* along a portion(s) of an aerospace connector, *etc.*)*.* In exemplary embodiments, the EMI absorbers and EMI absorbing compositions may have a sufficiently low filler loading level of the carbon nanostructure (CNS) filler (*e.g.,* at least about 0.1 weight percent but not more than about 5 weight percent, *etc.*) within the liquid crystal polymer (LCP) matrix such that the carbon nanostructure filler does not significantly change the rheology or mechanical properties of the matrix into which the carbon nanostructure filler is compounded and/or such that the density of the matrix remains substantially unchanged despite the addition of the carbon nanostructure filler. Advantageously, the EMI absorbers and EMI absorbing compositions disclosed herein may offer design flexibility, allowing for the incorporation of effective electromagnetic shielding without significantly increasing the size or weight of aerospace connectors.

Exemplary embodiments of the EMI absorbers and EMI absorbing compositions disclosed herein may also be used with high speed connectors. For example, exemplary embodiments of the EMI absorbers and EMI absorbing compositions disclosed herein may be used with high speed connectors for server backplanes, peripheral component interconnect express (PCIe), etc., which are moving to higher speed with noise in the 60 GHz range. Additional applications in which exemplary embodiments of the EMI absorbers and EMI absorbing compositions disclosed herein may be used include telecom infrastructure, wireless networks, satellite communication, security and defense.

With reference to the figures, FIG. 1 shows injection moldable thermoplastic EMI absorber pellets 100 including carbon nanostructure (CNS) filler *(*e*.g.,* about 1.5 weight percent, *etc.*) within a liquid crystal polymer (LCP) matrix according to an exemplary embodiment of the present disclosure. The pellets may be injection molded to form an EMI absorber having a one-piece monolithic construction.

In exemplary embodiments, a high-temperature, injection moldable thermoplastic EMI absorber includes about 1.5 weight percent of carbon nanostructure (CNS) filler within a liquid crystal polymer (LCP) matrix. With benefit of the LCP resin system, the EMI absorber has good high temperature resistance, high dimension stability, and a low coefficient of thermal expansion. In such exemplary embodiments, the EMI absorber may provide or include one or more (but not necessarily any or all of) the following features and benefits: injection moldable - ideal for complex shapes, cost effective for high volume, outstanding temperature stability, RoHS compliant, halogen-free per IEC-61249-2-21 standard, and low outgassing. Also in such exemplary embodiments, the EMI absorber may be configured to have the following properties: dark grey color, volume resistivity of about 10⁵ ohm-centimeters (ohm-cm), tensile strength of about 70 megapascals (MPa), tensile elongation of about 1.5 percent, Izod notched impact strength of about 75 joules per meter (J/m), flexural strength of 140 MPa, flexural modulus of about 9 gigapascals (GPa), molding shrinkage parallel to flow of about 0.1 percent, molding shrinkage transverse to flow of about 0.8 percent, and UL V0 flammability rating. In this example, the volume resistivity of 10⁵ ohm-cm is relatively high at a CNS loading of 1.5 weight percent. A higher CNS loading will make the absorber even more electrically conductive.

FIGS. 2 and 3 include line graphs of permittivity versus frequency from 18 gigahertz (GHz) to 40 GHz for six EMI absorbers having different carbon nanostructure (CNS) filler loadings (CNS weight percent of 0.5, 0.7, 0.8, 0.9, 1, and 1.5) within a liquid crystal polymer (LCP) matrix according to exemplary embodiments of the present disclosure. As shown in FIGS. 2 and 3, the EMI absorber with the highest CNS loading of 1.5 weight percent had the highest permittivity with the frequency range from 18 GHz to 40 GHz. Conversely, the EMI absorber with the lowest CNS loading of 0.5 weight percent had the lowest permittivity with the frequency range from 18 GHz to 40 GHz.

In exemplary embodiments, the matrix may include at least about 80 weight percent but not more than about 90 weight percent of the liquid crystal polymer. The matrix may include at least about 10 weight percent but not more than about 20 weight percent of one or more additives including glass reinforcement.

In exemplary embodiments, an electromagnetic interference (EMI) absorber comprises carbon nanostructure filler within a matrix. The matrix comprises liquid crystal polymer. The EMI absorber includes at least about 0.1 weight percent but not more than about 5 weight percent of the carbon nanostructure filler within the matrix.

In exemplary embodiments, the EMI absorber may be configured for use in aerospace applications, such as an aerospace connector, *etc.* For example, an aerospace connector may comprise an EMI absorber as disclosed herein that is configured to be operable for: reducing or eliminating electromagnetic interference that could otherwise degrade performance or cause malfunction of the aerospace connector, thereby helping maintain signal integrity of the aerospace connector; and/or minimizing electromagnetic emissions and susceptibility to external interference, thereby helping ensure compliance of the aerospace connector with regulatory standards for electromagnetic compatibility (EMC); and/or protecting electronic components from damage or malfunction caused by electromagnetic interference, thereby helping improve reliability of the aerospace connector. But the EMI absorbers disclosed herein may be used in other applications, industries, components, *etc.* such that EMI absorbers disclosed herein should not be limited to use with only aerospace connectors. For example, the EMI absorbers disclosed herein may be used with high speed connectors for server backplanes, peripheral component interconnect express (PCIe), etc., which are moving to higher speed with noise in the 60 GHz range. Additional applications in which exemplary embodiments of the EMI absorbers and EMI absorbing compositions disclosed herein may be used include telecom infrastructure, wireless networks, satellite communication, security and defense, *etc.*

In exemplary embodiments, the EMI absorber comprises injection moldable thermoplastic pellets including the matrix that comprises the liquid crystal polymer and at least about 1.5 weight percent of the carbon nanostructure filler within the matrix. In such exemplary embodiments, the injection moldable thermoplastic pellets absorber may be RoHS compliant and halogen-free per IEC-61249-2-21 standard and have a volume resistivity of at least about 10^5 or 10⁵ ohm-centimeters.

In exemplary embodiments, the EMI absorber includes at least about 1.5 weight percent of the carbon nanostructure filler within the matrix. And the EMI absorber may have a volume resistivity of at least about 10^5 or 10⁵ ohm-centimeters.

In exemplary embodiments, the EMI absorber includes at least about 0.5 weight percent but not more than about 3 weight percent of the carbon nanostructure filler within the matrix.

In exemplary embodiments, the EMI absorber includes at least about 0.5 weight percent but not more than about 1.5 weight percent of the carbon nanostructure filler within the matrix.

In exemplary embodiments, the EMI absorber includes about 0.5, 0.7, 0.8, 0.9, or 1 weight percent of the carbon nanostructure filler within the matrix.

In exemplary embodiments, the EMI absorber includes about 0.75 weight percent of the carbon nanostructure filler within the matrix.

In exemplary embodiments, the EMI absorber includes about 1 weight percent of the carbon nanostructure filler within the matrix.

In exemplary embodiments, the EMI absorber includes at least about 95 weight percent but not more than about 99.9 weight percent of the matrix.

In exemplary embodiments, the EMI absorber includes: at least about 0.5 weight percent but not more than about 3 weight percent of the carbon nanostructure filler within the matrix; and at least about 97 weight percent but not more than about 99.5 weight percent of the matrix.

In exemplary embodiments, the EMI absorber includes: at least about 0.5 weight percent but not more than about 1 weight percent of the carbon nanostructure filler within the matrix; and at least about 99 weight percent but not more than about 99.5 weight percent of the matrix.

In exemplary embodiments, the EMI absorber includes: about 0.5 weight percent of the carbon nanostructure filler within the matrix; and about 99.5 weight percent of the matrix.

In exemplary embodiments, the EMI absorber includes: about 0.75 weight percent of the carbon nanostructure filler within the matrix; and about 99.25 weight percent of the matrix.

In exemplary embodiments, the EMI absorber includes: about 1 weight percent of the carbon nanostructure filler within the matrix; and about 99 weight percent of the matrix.

In exemplary embodiments, the carbon nanostructure filler comprise one or more of: multi-walled carbon nanotubes within the matrix; single-walled carbon nanotubes within the matrix; and/or carbon nanostructures comprising a branched network of crosslinked carbon nanotube structures within the matrix.

In exemplary embodiments, the EMI absorber comprises a composition that includes the matrix that comprises the liquid crystal polymer and at least about 0.1 weight percent but not more than about 5 weight percent of the carbon nanostructure filler within the matrix, whereby the sufficiently low filler loading level of the carbon nanostructure filler within the matrix enables the carbon nanostructure filler to be mixed well in the matrix thereby providing low viscosity and good flowability for easily pouring, casting, or molding the composition into shapes or patterns.

In exemplary embodiments, the EMI absorber includes a sufficiently low filler loading level of the carbon nanostructure filler within the matrix such that the EMI absorber is lightweight.

In exemplary embodiments, the EMI absorber includes a sufficiently low filler loading level of the carbon nanostructure filler within the matrix such that the carbon nanostructure filler does not significantly change the rheology or mechanical properties of the matrix into which the carbon nanostructure filler is compounded.

In exemplary embodiments, the EMI absorber includes a sufficiently low filler loading level of the carbon nanostructure filler within the matrix such that the density of the matrix remains substantially unchanged after the carbon nanostructure filler has been compounded into the matrix. For example, density for a control (matrix without any CNS filler) was 1.5772. Density was 1.5758 for the matrix with 0.25 weight percent of carbon nanostructure filler was compounded into the matrix. Density was 1.5871 for the matrix with 0.5 weight percent of carbon nanostructure filler was compounded into the matrix. Density was 1.5562 for the matrix with 1 weight percent of carbon nanostructure filler was compounded into the matrix. These densities are examples only as other exemplary embodiments may be configured such the density is higher or lower.

In exemplary embodiments, the EMI absorber is configured to be operable with an attenuation of at least 20 decibels per centimeter (dB/cm) at frequencies from about 18 gigahertz (GHz) to about 60 GHz. For example, the EMI absorber may be configured to be operable with an attenuation of at least 20 dB/cm at frequencies from about 18 gigahertz (GHz) to about 60 GHz at 0 and 90 degree orientations.

In exemplary embodiments, the EMI absorber includes one or more additives, non-additive fillers, and/or glass reinforcement in the matrix. For example, the matrix may include at least about 10 weight percent but not more than about 20 weight percent of one or more additives including glass reinforcement.

In exemplary embodiments, the EMI absorber comprises thermoplastic injection moldable pellets. And the EMI absorber may be an injection molded EMI absorber having a one-piece monolithic construction.

Also disclosed are exemplary compositions for electromagnetic interference (EMI) absorbers. In exemplary embodiments, the composition comprises carbon nanostructure filler within a matrix. The matrix comprises liquid crystal polymer. And the composition includes at least about 0.1 weight percent to about 5 weight percent of the carbon nanostructure filler.

In exemplary embodiments, the composition may be configured for use in aerospace applications, such as an aerospace connector, *etc.* For example, an aerospace connector may comprise a composition as disclosed herein that is configured to be operable for: reducing or eliminating electromagnetic interference that could otherwise degrade performance or cause malfunction of the aerospace connector, thereby helping maintain signal integrity of the aerospace connector; and/or minimizing electromagnetic emissions and susceptibility to external interference, thereby helping ensure compliance of the aerospace connector with regulatory standards for electromagnetic compatibility (EMC); and/or protecting electronic components from damage or malfunction caused by electromagnetic interference, thereby helping improve reliability of the aerospace connector. But the compositions disclosed herein may be used in other applications, industries, components, *etc.* such that the composition disclosed herein should not be limited to use with only aerospace connectors. For example, the compositions disclosed herein may be used with high speed connectors for server backplanes, peripheral component interconnect express (PCIe), etc., which are moving to higher speed with noise in the 60 GHz range. Additional applications in which exemplary embodiments of the compositions disclosed herein may be used include telecom infrastructure, wireless networks, satellite communication, security and defense, *etc.*

In exemplary embodiments, the composition includes at least about 0.5 weight percent but not more than about 3 weight percent of the carbon nanostructure filler within the matrix.

In exemplary embodiments, the composition is RoHS compliant and halogen-free per IEC-61249-2-21 standard and has a volume resistivity of at least about 10⁵ ohm-centimeters.

In exemplary embodiments, the composition includes at least about 0.5 weight percent but not more than about 1.5 weight percent of the carbon nanostructure filler within the matrix.

In exemplary embodiments, the composition includes about 0.5, 0.7, 0.8, 0.9, or 1 weight percent of the carbon nanostructure filler within the matrix.

In exemplary embodiments, the composition includes about 0.75 weight percent of the carbon nanostructure filler within the matrix.

In exemplary embodiments, the composition includes about 1 weight percent of the carbon nanostructure filler within the matrix.

In exemplary embodiments, the composition includes at least about 95 weight percent but not more than about 99.9 weight percent of the matrix.

In exemplary embodiments, the composition includes: at least about 0.5 weight percent but not more than about 3 weight percent of the carbon nanostructure filler within the matrix; and at least about 97 weight percent but not more than about 99.5 weight percent of the matrix.

In exemplary embodiments, the composition includes: at least about 0.5 weight percent but not more than about 1 weight percent of the carbon nanostructure filler within the matrix; and at least about 99 weight percent but not more than about 99.5 weight percent of the matrix.

In exemplary embodiments, the composition includes: about 0.5 weight percent of the carbon nanostructure filler within the matrix; and about 99.5 weight percent of the matrix.

In exemplary embodiments, the composition includes: about 0.75 weight percent of the carbon nanostructure filler within the matrix; and about 99.25 weight percent of the matrix.

In exemplary embodiments, the composition includes: about 1 weight percent of the carbon nanostructure filler within the matrix; and about 99 weight percent of the matrix.

In exemplary embodiments, the carbon nanostructure filler comprise one or more of: multi-walled carbon nanotubes within the matrix; single-walled carbon nanotubes within the matrix; and/or carbon nanostructures comprising a branched network of crosslinked carbon nanotube structures within the matrix.

In exemplary embodiments, the composition includes a sufficiently low filler loading level of the carbon nanostructure filler within the matrix that enables the carbon nanostructure filler to be mixed well in the matrix thereby providing low viscosity and good flowability for easily pouring, casting, or molding the composition into shapes or patterns.

In exemplary embodiments, the composition includes a sufficiently low filler loading level of the carbon nanostructure filler within the matrix such that the composition is lightweight.

In exemplary embodiments, the composition includes a sufficiently low filler loading level of the carbon nanostructure filler within the matrix such that the carbon nanostructure filler does not significantly change the rheology or mechanical properties of the matrix into which the carbon nanostructure filler is compounded.

In exemplary embodiments, the composition includes a sufficiently low filler loading level of the carbon nanostructure filler within the matrix such that the density of the matrix remains substantially unchanged after the carbon nanostructure filler has been compounded into the matrix.

In exemplary embodiments, the composition is configured to be operable with an attenuation of at least 20 decibels per centimeter (dB/cm) at frequencies from about 18 gigahertz (GHz) to about 60 GHz. For example, the composition may be configured to be operable with an attenuation of at least 20 dB/cm at frequencies from about 18 gigahertz (GHz) to about 60 GHz at 0 and 90 degree orientations.

In exemplary embodiments, the composition includes one or more additives, non-additive fillers, and/or glass reinforcement in the matrix. For example, the matrix may include at least about 10 weight percent but not more than about 20 weight percent of one or more additives including glass reinforcement.

In exemplary embodiments, the composition is injection moldable. The composition may comprise thermoplastic injection moldable pellets. And an EMI absorber may be injection molded from the composition.

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. For example, when permissive phrases, such as "may comprise", "may include", and the like, are used herein, at least one embodiment comprises or includes the feature(s). As used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (*e.g*., "between" versus "directly between," "adjacent" versus "directly adjacent," *etc.*)*.* As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about", equivalents to the quantities are included.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. An electromagnetic interference (EMI) absorber comprising carbon nanostructure filler within a matrix, wherein:
the matrix comprises liquid crystal polymer; and
the EMI absorber includes at least about 0.1 weight percent but not more than about 5 weight percent of the carbon nanostructure filler within the matrix.

2. The EMI absorber of claim 1, wherein the EMI absorber comprises injection moldable thermoplastic pellets including the matrix that comprises the liquid crystal polymer and at least about 1.5 weight percent of the carbon nanostructure filler within the matrix.

3. The EMI absorber of claim 2, wherein the injection moldable thermoplastic pellets are RoHS compliant and halogen-free per IEC-61249-2-21 standard and have a volume resistivity of at least about 10⁵ ohm-centimeters.

4. The EMI absorber of claim 1, wherein the EMI absorber includes at least about 1.5 weight percent of the carbon nanostructure filler within the matrix.

5. The EMI absorber of claim 4, wherein the EMI absorber has a volume resistivity of at least about 10⁵ ohm-centimeters.

6. The EMI absorber of claim 1, wherein the EMI absorber includes at least about 0.5 weight percent but not more than about 3 weight percent of the carbon nanostructure filler within the matrix.

7. The EMI absorber of claim 1, wherein the EMI absorber includes at least about 0.5 weight percent but not more than about 1.5 weight percent of the carbon nanostructure filler within the matrix.

8. The EMI absorber of any one of the preceding claims, wherein the carbon nanostructure filler comprise one or more of:
multi-walled carbon nanotubes within the matrix;
single-walled carbon nanotubes within the matrix; and/or
carbon nanostructures comprising a branched network of crosslinked carbon nanotube structures within the matrix.

9. The EMI absorber of any one of the preceding claims, wherein the EMI absorber comprises a composition that includes the matrix that comprises the liquid crystal polymer and the carbon nanostructure filler within the matrix, whereby the sufficiently low filler loading level of the carbon nanostructure filler within the matrix enables the carbon nanostructure filler to be mixed well in the matrix thereby providing low viscosity and good flowability for easily pouring, casting, or molding the composition into shapes or patterns.

10. The EMI absorber of any one of the preceding claims, wherein the EMI absorber is configured to be operable with an attenuation of at least 20 decibels per centimeter (dB/cm) at frequencies from about 18 gigahertz (GHz) to about 60 GHz.

11. The EMI absorber of any one of the preceding, wherein the EMI absorber comprises injection moldable thermoplastic pellets that are made from the matrix that comprises the liquid crystal polymer and the carbon nanostructure filler within the matrix.

12. The EMI absorber of claim 11, wherein the injection moldable thermoplastic pellets are RoHS compliant and halogen-free per IEC-61249-2-21 standard and have a volume resistivity of at least about 10⁵ ohm-centimeters.

13. The EMI absorber of any one of claims 1 to 10, wherein the EMI absorber comprises an injection moldable EMI absorbing composition that includes the matrix that comprises the liquid crystal polymer and the carbon nanostructure filler within the matrix.

14. The EMI absorber of any one of claims 1 to 10, wherein the EMI absorber is injection molded from a composition that includes the matrix that comprises the liquid crystal polymer and the carbon nanostructure filler within the matrix such that the EMI absorber has a one-piece monolithic construction.

15. An aerospace connector comprising the EMI absorber of any one of the preceding claims that is configured to be operable for:
reducing or eliminating electromagnetic interference that could otherwise degrade performance or cause malfunction of the aerospace connector, thereby helping maintain signal integrity of the aerospace connector; and/or
minimizing electromagnetic emissions and susceptibility to external interference, thereby helping ensure compliance of the aerospace connector with regulatory standards for electromagnetic compatibility (EMC); and/or
protecting electronic components from damage or malfunction caused by electromagnetic interference, thereby helping improve reliability of the aerospace connector.
